# EUROPEAN PATENT APPLICATION

(11) **EP 4 057 068 A1**
(43) Date of publication of application: **14.09.2022**
(21) Application number: 21161486.2
(22) Date of filing: 09.03.2021
(51) Int. Cl.: G03F 7/20, H01L 21/683

(54) **APPARATUS COMPRISING AN ELECTROSTATIC CLAMP AND METHOD**

(71) Applicant: ASML Netherlands B.V., 5500 AH Veldhoven (NL)
(72) Inventor: MAKARENKO, Ksenia, Sergeevna, 5500 AH Veldhoven (NL); VAN DE KERKHOF, Marcus, Adrianus, 5500 AH Veldhoven (NL); DOLGOV, Alexandr, 5500 AH Veldhoven (NL)
(74) Representative: ASML Netherlands B.V.

(57) **Abstract**

An electrostatic clamp for clamping an object, the electrostatic clamp comprising an electroadhesive layer comprising a plurality of conductive compressible material elements coated with insulating material, wherein the electroadhesive layer is configured to electrically change adhesion to the object for clamping and unclamping the object.

## Description

### FIELD

The present invention relates to an apparatus comprising an electrostatic clamp, and a method of its operation. More particularly, but not exclusively, the apparatus may be for use in a lithographic apparatus, the electrostatic clamp being configured to clamp an object such as a patterning device or substrate during lithographic patterning.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus may typically use high-voltage electrostatic clamps (e.g. with a voltage of the order of 3kV) in order to clamp substrates and patterning devices, for example, during patterning operations. High electric field, created by such high voltage, may lead to the formation of the cycle-induced charges on the electrostatic clamp. These charges are trapped in the glass of the electrostatic clamp and create attractive forces that may lead to substrate load grid and substrate sticking. Moreover, high e-fields charge neutral particles and lead to a substrate backside and a table top defectivity and defect driven local charges. High electric field, created by such voltage, causes a number of issues such as discharging, particle formation, treeing (e.g. through the glass), electrical breakdown etc. These may lead to e.g. an overlay, patterning device sticking, breakage of the parts, and, as a consequence, patterning device clamp swap.

The high-voltage electrostatic clamps also limit the clamping voltage that can be applied. As a result, production speed of the lithographic apparatus is limited too.

Furthermore, high applied voltages require usage of high-voltage electronics, cables and shielding (e.g. in scanning patterning device stage modules).

It may be desirable to provide an apparatus and method that overcomes or mitigates one or more problems associated with the prior art.

### SUMMARY

According to a first aspect of the invention, there is provided an electrostatic clamp for clamping an object, the electrostatic clamp comprising an electroadhesive layer comprising a plurality of conductive compressible material elements coated with insulating material, wherein the electroadhesive layer is configured to electrically change adhesion to the object for clamping and unclamping the object.

This may have an advantage of operating the clamp at relatively low voltages (e.g. <100V), which is intrinsically safe for discharges and cycle-induced charges and defect driven local charges etc. An advantage of using the clamp may be that the usage of high-voltage electronics, cables and shielding may be avoided. The high e-field (e.g. of the order of 0.1GV/m) may be avoided and thus electrical breakdown and treeing through the glass of the clamp may be reduced or eliminated. Also, the production speed of the lithographic apparatus LA may be increased due to the use of the clamp.

The electroadhesive layer may be a nanocomposite electroadhesive. The nanocomposite electroadhesive may be soft.

The electroadhesive layer may extend over substantially all of the surface of the clamp facing the object.

The electroadhesive layer may comprise an electrode in electrical connection with the elements and physically connecting the elements to a body of the electrostatic clamp.

When the adhesion is electrically off, only the contacting elements contribute to the surface adhesion, as the surrounding non-contacting elements do not contribute to the van der Waals adhesion.

Electrically on adhesion is determined by electrostatic charge accumulated on the elements both in contact and in close proximity (e.g. within 10nm) of the object, because the electrostatic forces are effective at greater distances than van der Waals forces.

The conductive compressible element may comprise a fibre. The fibre may comprise elongated element, porous structure, circular structure, or any structure that can change its morphology when a voltage is applied.

The electrostatic clamp may be at least one of a gripper, a reticle pod or a vacuum pre aligner.

The object may be a substrate or a patterning device or a mirror or a witness sample or a particle or an object of a lithographic apparatus.

The elements may have an average diameter in a range of 1-100nm, preferably 5-20nm.

The elements may comprise at least one of: fiber, foam, nanotube, carbon nanotube, nanowire, nanorod, nanoporous structure, graphene, and fullerene.

The carbon nanotube may be (vertically aligned) multiwalled.

The elements may be flexible.

The elements may comprise at least one of carbon, silver, and boron nitride. Carbon may allow an increased packing density of elements (e.g. when compared with silver) due to the graphene structure of Carbon preventing electrical interactions between the elements.

The elements may have a density in a range of 1-20%.

In an embodiment, the elements may have a conductivity in a range of 10^2 - 10^7S/m. The insulating material is electrically insulating. The insulating material may be considered to be a dielectric material. The insulating material may have an electrical resistivity in a range of 10^4 - 10^18 Ωm, preferably in a range of 10^5 - 10^8 Qm. The insulating material may have a dielectric constant in a range of 5-30, preferably in a range of 7-18. The elements may be compressible or flexible and have a Young's modulus in a range of 1 - 1000 MPa, preferably in a range of 10-300 MPa. The elements may deform to conform the surface of the object facing the elements. The elements may deform to absorb defect particles on the surface of te object facing the elements.

The insulating material may have an average thickness in a range of 0.1-50nm, preferably 1-15nm.

The insulating material may comprise at least one of: Al₂O₃, HfO₂, ZrO, and SiO₂.

The insulating material may be preferably robust, a relatively high breakdown voltage material (Al2O3 is about 5GV), wear resistant, stable under the environments in which the electrostatic clamp is being used, and able to be applied relatively well (e.g. using ADL). The thinner the insulating material is then the lower the voltage that may be needed (as the distance between the elements and the object is reduced) but reducing the thickness too much may mean there is more likelihood of breaks in the insulating material which may allow current to flow.

The electrostatic clamp may comprise a plurality of burls and wherein the electroadhesive layer may be located adjacent to the burls.

The electroahesive layer may extend over substantially all of the surface of the clamp facing the object except in the location of the plurality of burls. In practice, there may be spaces between the electroahesive layer and the burls (e.g. due to manufacturing tolerances).

The burls may have an advantage of enabling the desired distance between the clamp and the object to be achieved because the electroadhesive layer may bend in contact with the object.

The elements of the electroadhesive layer, in use, may extend further from the electrostatic clamp than the burls when the adhesion of the electroadhesive layer is electrically switched on. The elements may extend up to 10%, or up 20% further than the burls.

According to a second aspect of the present invention, there is provided an assembly comprising the electrostatic clamp as described above and a voltage supply configured to charge at least one of the electroadhesive layer and the object.

The electrostatic clamp and/or the object may be respectively movable such that the electroadhesive layer is in contact with or close proximity to the object.

Close proximity may be considered to be within 10nm distance. That is, the effect of electrostatic adhesion may start occurring at about 10nm distance.

A voltage of the voltage supply may be at least one of under 250V, 200V, 150V, 100V, 75V, 50V, 40V, 30V, 20V, and 10V.

The voltage of the voltage supply may be considered to be relatively low.

According to a third aspect of the present invention, there is provided a lithographic apparatus arranged to project a pattern from a patterning device onto a substrate, wherein the lithographic apparatus comprises an illumination system configured to condition a radiation beam, wherein the illumination system is configured to project the radiation beam onto the patterning device, wherein the lithographic apparatus comprises the apparatus of any preceding claim and the object to be clamped comprises the patterning device or the substrate.

The radiation may be EUV radiation and the lithographic apparatus may be an EUV lithographic apparatus. The apparatus may be configured to be used in a lithographic apparatus or outside a lithographic apparatus, e.g. in an e-beam system.

According to a fourth aspect of the present invention, there is provided a method of operating an electrostatic clamp for clamping an object, wherein the electrostatic clamp comprises an electroadhesive layer comprising a plurality of conductive compressible material elements coated with insulating material, the method comprising: electrically changing adhesion of the electroadhesive layer to the object for clamping the object and unclamping the object.

The electrostatic clamp may be used in ambient or vacuum conditions.

The object may be a substrate or a patterning device or a mirror or a witness sample or a particle or an object of a lithographic apparatus.

The method may further comprise charging at least one of the electroadhesive layer and the object using a voltage supply, and respectively moving the electrostatic clamp and/or the object such that the electroadhesive layer is in contact with or close proximity to the object.

The voltage of the voltage supply may be applied non-continuously.

The method may further comprise applying a voltage of at least one of under 250V, 200V, 150V, 100V, 75V, 50V, 40V, 30V, 20V, and 10V to the electroadhesive layer or the object using the voltage supply.

The object may comprise a patterning device. The method may further comprising applying a voltage to a backside of the patterning device.

There may be a plasma shielding construction or the patterning device backside coating may be sufficiently retracted from an edge of the patterning device to prevent EUV-induced plasma from de-charging the reticle backside. The reticle backside may be negatively charged as this may have an advantage of repelling the more mobile plasma electrons.

The method may further comprise applying a voltage to the electroadhesive layer.

The method may further comprise making electrical contact from the voltage supply to the electroadhesive layer.

The method may further comprise applying the voltage to the electroadhesive layer wirelessly. The method may further comprise applying the voltage to the electroadhesive layer via induction. This may be by using a circuit with one or more capacitors or a rechargeable battery.

The method may further comprise applying the voltage to the electroadhesive layer during patterning device load (i.e. charging the electroadhesive layer during patterning device load). The method may further comprise decharging the electroadhesive layer during patterning device unload. This may have an advantage that no electrical contact is made with the patterning device.

The method may comprise spatially modifying the adhesion of the electroadhesive layer over time.

The method may further comprise spatially modifying the charge on the electroadhesive layer or the object over time. This may allow differential clamping, i.e. allowing parts of the object (e.g. a substrate) to be released at different times, (i.e. the whole of the object is not released all at once). If an object (e.g. substrate) is released all at once then it may vibrate (e.g. at a resonant frequency) and contact the burls (which are relatively strong) and this may cause damage to the object.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a schematic diagram of patterning device electrostatic clamp in accordance with an embodiment of the present invention;
- Figure 3 depicts a schematic diagram of an electroadhesive layer in accordance with an embodiment of the present invention;
- Figures 4a-4d depicts schematic diagrams of a substrate electrostatic clamp in different stages of a clamping procedure in accordance with an embodiment of the present invention;
- Figure 5 depicts a flow diagram of a method of a clamping procedure in accordance with an embodiment of the present invention.

### DETAILED DESCRIPTION

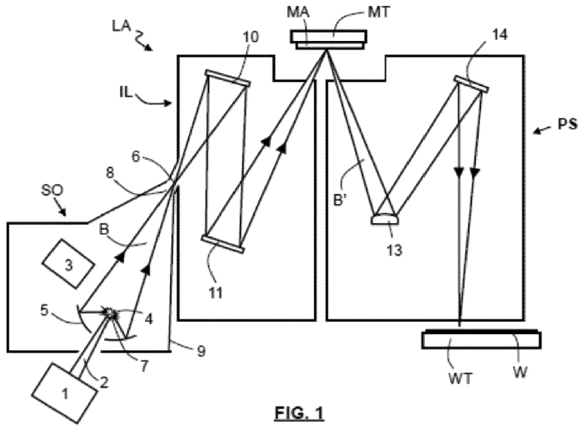

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

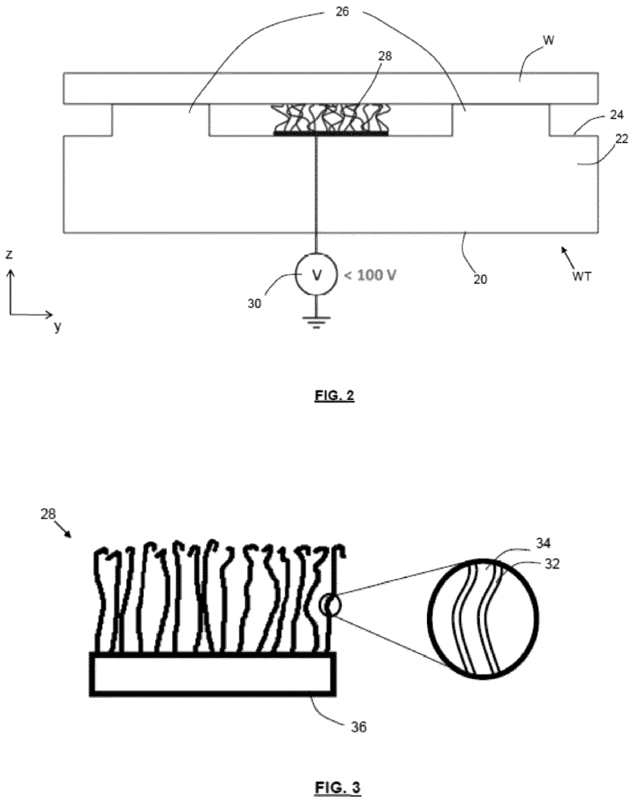

Figure 2 shows a cross section of the substrate table WT configured to support the substrate W in more detail. The cross section is in an x-plane, extending vertically in the z-direction and horizontally in the y-direction in the orientation shown. The y-direction may be taken as the direction of scanning of the lithographic apparatus and the x-direction may be taken as perpendicular to the scanning direction. The substrate table WT comprises an electrostatic clamp 20 which is configured to clamp the substrate W during lithographic operations. The clamp 20 comprises a body 22 having a surface 24 (i.e. a clamping surface) facing the substrate W in use. Protruding from the surface 24 of the body 22 is a plurality of burls 26, which act to separate the clamped substrate W from the body 22. The burls 26 may, for example, have a height of around 10 µm, and may, collectively, cover around 1% of the surface 24 of the clamp 20. The burls 26 may be made from SiSiC. It will be appreciated that many features of the clamp 20 (e.g. wiring, additional electrodes) are omitted for simplicity.

The clamp 20 may be considered to be part of the lithographic apparatus LA or may be considered to be part of an apparatus that forms part or is separate to the lithographic apparatus LA. The clamp 20 may be configured to be used in a lithographic apparatus LA or outside a lithographic apparatus LA, e.g. in an e-beam system. Although a substrate table WT and a substrate W is used to illustrate this embodiment, it will be appreciated that the electrostatic clamp 20 may be used to clamp other objects, e.g. a patterning device MA or a mirror or a witness sample or a particle or an object of a lithographic apparatus LA. Therefore, the features and advantages described are not only applicable to clamping a substrate W and may be for other objects as well.

As shown in Figure 2, located between the burls 26 is an electroadhesive layer 28. More generally, the electroadhesive layer 28 may be adjacent one or more burls 26. The burls 26 provide stiffness in xyz directions, while the electroadhesive layer 28 does the clamping. Although the electroadhesive layer 28 is shown covering only a portion of the surface 24 of the body 22 of the clamp 20, it will be appreciated that, in other embodiments, the electroadhesive layer 28 may extend over substantially all of the surface 24 of the body 22 facing the substrate W, except in the location of the plurality of burls 26. In practice, there may be spaces between the electroadhesive layer 28 and the burls 26 (e.g. due to manufacturing tolerances). It will be appreciated that, in some embodiments, there may not be any burls 26 present (e.g. there may only be the electroadhesive layer 28 between the surface 24 of the body 22 of the clamp 20 and the object being clamped in use). In this case, the electroadhesive layer 28 may extend over substantially all of the surface 24 of the body 22 facing the substrate W.

The electroadhesive layer 28 is connected to a voltage supply 30 (i.e. electrical contact is made from the voltage supply 30 to the electroadhesive layer 28), which in this embodiment provides a voltage of less than 100V. This may be considered to be a relatively low voltage. In other embodiments, the voltage may be at least one of under 250V, 200V, 150V, 75V, 50V, 40V, 30V, 20V, and 10V.

Figure 3 shows the electroadhesive layer 28 in more detail. The electroadhesive layer 28 comprises a plurality of conductive fibres 32 coated with insulating material 34. This allows the substrate W to be clamped at a low voltage (e.g. <100V). The insulating material 34 keeps the conductive fibres 32 separated from the substrate W. In other embodiments, the electroadhesive layer 28 may be used instead of an e-sheet for a modular clamp. More generally, the fibre may be a conductive compressible material element. The fibre may comprise elongated element, porous structure, circular structure, or any structure that can change its morphology when a voltage is applied.

The electroadhesive layer 28 may comprise an electrode 36 in electrical connection with the fibres 32 and physically connecting the fibres 32 to the body 22 of the electrostatic clamp 20. Electrical contact may be made between the voltage supply 30 and the electrode 36. The electrode 36 may comprise TiN (Titanium nitride). In other embodiments, different materials may be used for the electrode 36.

The electroadhesive layer 28 may be considered to be a nanocomposite electroadhesive. The fibres 32 may be nanotubes. The fibres 32 may be flexible. Flexibility may enhance the area which is in close proximity with the substrate W (within approximately 10 nm), which will enhance the electrical attraction force. This close proximity may be referred to as intimate contact. If the fibres are not flexible, only a very limited contact area may be formed, so no appreciable adhesion force may form. Thus, the nanocomposite electroadhesive may be considered to be soft. Since the electroadhesive layer 28 is soft, particles may be absorbed by the electroadhesive layer 28 (i.e. may be taken away from the surface of the electroadhesive layer 28). If a particle remains in between the substrate W and the electroadhesive layer 28, there may not be intimate contact between the substrate W and the electroadhesive layer 28 in this location. Thus, the electrical attraction force may be reduced.

The fibres 32 may have a diameter in a range of 1-100nm, preferably 5-20nm (e.g. 10nm). The insulating material 34 may have an average thickness in a range of 0.1-50nm, preferably 1-10nm. The thinner the insulating material 34 is then the lower the voltage that may be needed (as the distance between the fibres 32 and the substrate W is reduced) but reducing the thickness too much may mean there is more likelihood of breaks in the insulating material 34 which may allow current to flow.

The voltage supply 30 is configured to electrically switch on adhesion of the electroadhesive layer 28 for clamping the substrate W and electrically switch off the adhesion of the electroadhesive layer 28 for unclamping the substrate W. That is, the voltage of <100V may be applied to the electroadhesive layer 28 from the voltage supply 30 through the electrode 36 to clamp the substrate W, e.g. when the substrate W is in contact with the clamp 20. The voltage may be turned down far enough or removed (e.g. turned off) to unclamp the substrate W, e.g. so that the substrate W may be moved away from the clamp 20.

This may be achieved in this way because the electroadhesive layer 28 has low (OFF) adhesion through the roughness and reduced contract area with the substrate W. The density of the fibres 32 in the electroadhesive layer 28 is such that they can easily be deformed so that only a few fibres of the electroadhesive layer 28 surface will effectively contribute to the surface adhesion (i.e. between the electroadhesive layer 28 and the substrate W). When the adhesion is electrically off, only the contacting fibres 32 (i.e. the fibres 32 in contact with the substrate W) contribute to the surface adhesion, as the surrounding non-contacting fibres 32 do not contribute to the van der Waals adhesion.

Voltage-tunable electrostatic attraction gives a strong (ON) adhesion because it is determined by the electrostatic charge accumulated on the fibres 32 that are both in contact and in close proximity of the substrate W. Close proximity may be considered to be within 10nm distance. That is, the effect of electrostatic adhesion may start occurring at about 10nm distance. Electrically on adhesion is determined by electrostatic charge accumulated on the fibres 32 both in contact and in close proximity (e.g. within 10nm) of the substrate W, because the electrostatic forces are effective at greater distances than van der Waals forces.

The density of the fibres 32 in the electroadhesive layer 28 may be such that a particular voltage provides a desired adhesion force. The greater the density of fibres 32 per unit area then the greater the adhesion force. Thus, it may be desired to have as large a density of fibres as possible. However, on the other hand, the density may be desired to be low enough so that the fibres can bend and move (e.g. when the substrate comes into contact with them or when voltage is applied so they can stretch). As an example, the density of fibres may be 1%. A density of 1% means that the fibres cover 1% of the area that the electroadhesive layer 28 covers. A density of 1% may be the fibre density for a gripper. In some examples, the density of the fibres may be greater than 1 %, e.g. up to 20% fibre density. A denser packing of the fibres may increase the overall adhesion force.

As a fibre bends 32, additional parts of the fibre 32 may come into contact with the substrate W and part of the bent fibre 32 may extend along, and be parallel to, the surface of the substrate W. Each additional part of the fibre 32 that comes into contact with the substrate W may contribute to the electro adhesion (e.g. at or near the bending location). However, the part of the fibre 32 that was already in contact with the substrate W (i.e. that is now parallel to the surface of the substrate W) may not contribute to the electro adhesion anymore and it may only be the additional part (at or near the bending location) of the bent fibre 32 that will contribute.

The electroadhesive layer 28 may provide different adhesive forces depending on the applied voltage. By applying <100 V, then it may be possible to achieve up to a hundred times increase in adhesion forces when compared to the adhesion forces with no voltage.

When the voltage is applied to the electroadhesive layer 28 (i.e. when the adhesion of the electroadhesive layer 28 is electrically switched on), the fibres 32 of the electroadhesive layer may extend further from the surface 24 of the clamp 20 than the burls 26. This is because the fibres 32 may at least partially repel the other fibres 32 when they are charged by the voltage supply 30 so that they stretch out further. In some embodiments, the fibres 32 may extend up to 10%, or up 20% further than the burls 26. Thus, if the voltage is turned on before the substrate W is in contact with the clamp 20, and then the clamp 20 is moved towards the substrate W (or vice versa) then the electroadhesive layer 28 will come into contact with the substrate W before the burls 26 will. The clamping will begin as soon as the substrate W is within the distance when the electrostatic adhesion is effective. The substrate W and the clamp 20 may come closer together until the substrate W comes into contact with the burls 26. Thus, the burls 26 may have an advantage of enabling the desired distance between the clamp 20 and the substrate W to be achieved because the electroadhesive layer 28 may bend in contact with the substrate W.

In this embodiment, the electroadhesive layer 28 is an Al₂O₃-CNT (carbon nanotube) layer. That is, the fibres 32 are carbon and the insulating material 34 is aluminium oxide. The carbon nanotube may be (vertically aligned) multiwalled. Carbon may beneficially allow an increased packing density of fibres 32 (e.g. when compared with silver) due to the graphene structure of carbon preventing electrical interactions between the fibres 32. It will be appreciated that other materials may be used for the fibres 32. For example, the fibres 32 may comprise at least one of silver, and boron nitride.

The insulating material 34 may be preferably robust, a relatively high breakdown voltage material (Al₂O₃ is about 5GV), wear resistant, stable under the environments in which the electrostatic clamp is being used, and able to be applied relatively well (e.g. using atomic layer deposition). It will be appreciated that other materials may be used for the insulating material 34. For example, the insulating material 34 may comprise at least one of HfO₂, ZrO, SiO₂, and glass.

Since the clamp 20 operates at relatively low voltages (e.g. <100V), it is intrinsically safe for discharges and cycle-induced charges and defect driven local charges etc. Advantageously, the clamp 20 may mean that substrate load grid and substrate sticking may be reduced or stopped. The low voltage used by the clamp 20 may be in comparison with high voltage clamps (e.g. of the order of 3kV). An advantage of using the clamp 20 of Figure 2 is that the usage of a high-voltage electronics, cables and shielding may be avoided. The high e-field (e.g. of the order of 0. 1GV/m) may be avoided and thus electrical breakdown and treeing through the glass of the clamp may be reduced or eliminated. Also, the production speed of the lithographic apparatus LA may be increased due to the use of the clamp 20.

The clamp 20 and the voltage supply 30 may be configured to spatially modify the adhesion of the electroadhesive layer 28 over time. The charge on the electroadhesive layer 28 may be spatially modified over time. That is, different parts of the electroadhesive layer 28 may be provided with different voltages, and thus different charges at different times. This may allow segmented and/or differential clamping, i.e. allowing parts of the substrate W to be clamped and released at different times, (i.e. the whole of the substrate W is not clamped or released all at once). If a substrate W is released all at once then it may vibrate (e.g. at a resonant frequency) and contact the burls 26 (which are relatively strong) and this may cause damage to the substrate W.

The clamp 20 may be used for an EUV lithographic apparatus and for a DUV lithographic apparatus. The clamp 20 may function in ambient or vacuum environment. Advantageously, the clamp 20 may be used as a common clamp for both EUV and DUV.

The clamp 20 may also be used as a replacement for grippers, reticle pods and vacuum pre aligner, in both DUV and EUV.

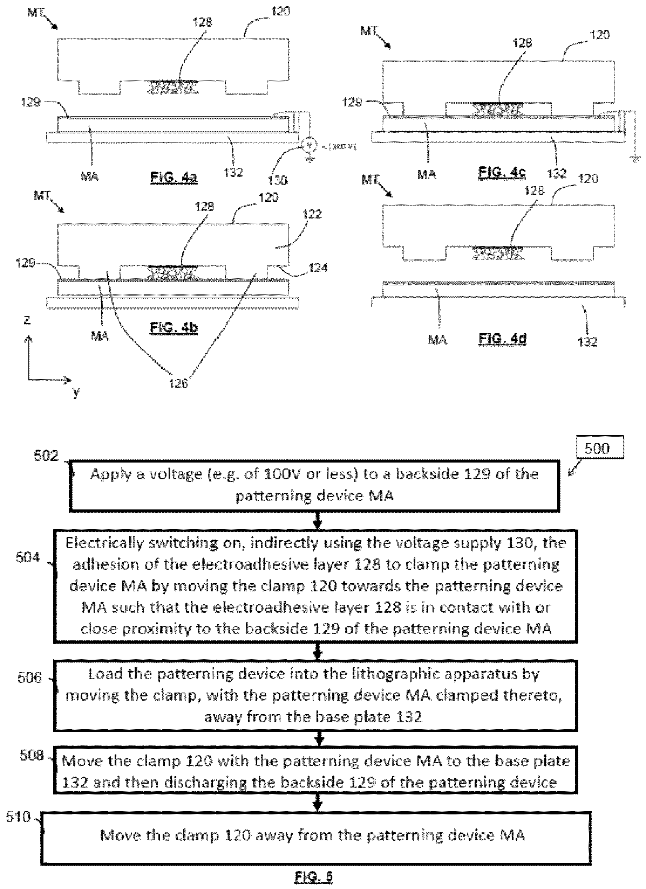

Figures 4a-4d illustrate another embodiment of the invention. Turning first to Figure 4b, which shows a cross section of the support structure MT configured to support a patterning device MA (e.g., a mask) in more detail. The cross section is in an x-plane, extending vertically in the z-direction and horizontally in the y-direction in the orientation shown. The y-direction may be taken as the direction of scanning of the lithographic apparatus and the x-direction may be taken as perpendicular to the scanning direction. The support structure MT comprises an electrostatic clamp 120 which is configured to clamp the patterning device MA during lithographic operations.

It will be appreciated that the electrostatic clamp 120 for clamping the patterning device MA is similar to the electrostatic clamp 20 for clamping the substrate W and so generally only the differences will be recited.

The clamp 120 comprises a body 122 having a surface 124 (i.e. a clamping surface) facing the patterning device MA in use. Protruding from the surface 124 of the body 122 is a plurality of burls 126, which act to separate the clamped patterning device MA from the body 122.

Located between the burls 126 is an electroadhesive layer 128. The burls 126 provide stiffness in xyz directions, while the electroadhesive layer 128 does the clamping. The electroadhesive layer 128 comprises a plurality of conductive fibres coated with insulating material similar to the electroadhesive layer 28 of clamp 20 of Figure 3.

Figures 4a-4d illustrate a clamping procedure for the patterning device MA. As shown in Figure 4a, the patterning device MA includes a backside 129. The backside 129 is a floating conductive film that may be charged to a desired potential, e.g. by a voltage supply 130. The voltage supply 130 in this embodiment provides a voltage of less than 100V. This may be considered to be a relatively low voltage. In other embodiments, the voltage may be different, but still considered to be low.

The patterning device MA may be resting on a base plate 132, i.e. the front side (opposite the backside 129) of the patterning device MA may be in contact with the base plate 132. Once the backside 129 is charged, the clamp 120 may move down towards the patterning device MA. In other embodiments, the clamp may move down to the patterning device MA before the backside 129 is charged.

As shown in Figure 4b, when the backside 129 of the patterning device is in close proximity with the electroadhesive layer 128 of the clamp 120, the backside 129 is attracted to the electroadhesive layer 128 located in between the burls 126 and which adhesion can be tuned by the presence/absence of electric field. The electroadhesion between the electroadhesive layer 128 and the backside 129 may overcome the gravity or other forces (e.g. surface adhesion) acting on the patterning device MA to keep it on the base plate 132. That is, the patterning device MA becomes clamped to the clamp 120, and can be moved by the clamp 120. It will be appreciated that the burls 126 will come into contact with the backside 129 of the patterning device MA. In other embodiments, the patterning device may be moved towards the clamp instead, or as well as, the movement of the clamp towards the patterning device. That is, there is relative movement between the patterning device and the clamp such that the electroadhesive layer is in close proximity to the backside of the patterning device.

Once, the patterning device MA is clamped to the clamp 120, the clamp 120 (with the patterning device MA attached) may move away (i.e. up) from the base plate 132, e.g. be loaded into the lithographic apparatus LA for operation etc.

As shown in Figure 4c, after operation, the clamp 120 moves down while the patterning device MA is still clamped. Once the patterning device MA is in contact with the base plate 132, the backside 129 of the patterning device MA may be discharged, e.g., by connecting to ground.

When the backside 129 of the patterning device MA is discharged, there is no strong adhesion to the electroadhesive layer 128. Figure 4d illustrates the clamp 120 moving away from the patterning device MA, i.e. leaving the patterning device MA behind on the base plate 132 (e.g. the patterning device MA is unloaded).

It will be appreciated that the clamping procedure of Figures 4a-4d allows the voltage of the voltage supply 130 to be applied non-continuously. The backside 129 of the patterning device MA is charged by the voltage supply 130 and then the voltage supply 120 may be disconnected. However, as the backside 129 is charged with respect to the clamp 120, the electroadhesive layer 128 is attracted to the backside 129 (and vice versa) such that the patterning device MA is clamped to the clamp 120. Thus, clamping of the patterning device MA may be carried out without a voltage being applied continuously. This may advantageously allow a reduction in the weight of the patterning device MA stage (e.g. to allow higher accelerations) or to enable larger patterning device MA sizes (e.g. 12" reticles).

In an example of a layer of insulating material of 10nm and a voltage of 100 V, the local clamping pressure between a fibre of the electroadhesive layer 128 and patterning device may be 5 MPa (previous (high voltage) clamps may have ∼0.1 V/nm, equalling -50 kPa). Thus, a fibre density of ∼1 % may be sufficient to achieve similar clamping pressure to the previous (high voltage) clamp. Alternatively, the layer of the insulating material may be reduced to ∼1 nm to get similar clamping pressure.

To prevent the EUV-induced plasma from de-charging the reticle backside 129 once it has been charged by the voltage supply 130, plasma shielding may be implemented, or the reticle backside 129 coating may be sufficiently retracted from an edge of the patterning device MA. In addition, it may be beneficial to choose a negative reticle backside 129 voltage, as this will repel the more mobile plasma electrons.

Figure 5 depicts a flow diagram 500 of a method of clamping the patterning device MA.

In step 502, the backside 129 of the patterning device MA is charged using the voltage supply 130 (e.g. of 100V or less). That is, by applying a voltage (e.g. of 100V or less) to a backside 129 of the patterning device MA.

In step 504, the clamp 120 is moved towards the patterning device MA such that the electroadhesive layer 128 is in contact with or close proximity to the backside 129 of the patterning device MA. That is, electrically switching on, using the voltage supply 130 (indirectly through the backside 129 in this case), the adhesion of the electroadhesive layer 128 to clamp the patterning device MA. It will be appreciated that, in some embodiments, the clamp 120 may be moved before the backside 129 of the patterning device MA is charged. In this case, as soon as the voltage (applied to the backside of the reticle) was switched on then the adhesion of the electroadhesive layer 128 would be electrically switched on to clamp the patterning device MA.

In step 506, the clamp 120, with the patterning device MA clamped thereto, moves away from the base plate 132, e.g. to be loaded into the lithographic apparatus LA for operation etc.

In step 508, the clamp 120 moves back towards the base plate 132 with the patterning device MA coming into contact with the base plate 132 again and then the backside 129 of the patterning device MA is discharged, e.g., by connecting to ground. The adhesion of the electroadhesive layer is electrically switched off (by the grounding of the backside of the patterning device MA) to unclamp the patterning device MA.

In step 510, the clamp 120, now with the patterning device MA not attached thereto, is moved away from the base plate 132. That is, the clamp 120 moves away from the patterning device MA as there is no strong adhesion between the backside 129 of the patterning device MA and the electroadhesive layer 128.

In other embodiments, the electrostatic layer 128 of the clamp 120 may be charged during patterning device MA load sequence and be de-charged during the patterning device MA unload sequence. In this case, the voltage may be applied to the electroadhesive layer 128 (e.g. by making electrical contact from the voltage supply 130 to the electroadhesive layer 128 during patterning device MA load). This means that electrical contact would not be required with the patterning device MA. That is, the reticle backside 129 would not need to be charged by the voltage supply 130 and the voltage supply 130 may instead charge the electrostatic layer 128 of the clamp 120. In this case, when the electrostatic layer 128 of the clamp 120 is in close proximity to the backside 129 of the patterning device MA, the electroadhesive layer 128 would still be attracted to the backside 129 (and vice versa) such that the patterning device MA is clamped to the clamp 120.

In some embodiments, the electrostatic layer 128 of the clamp 120 may be charged wirelessly by induction, e.g. using a circuit with one or more capacitors, or a rechargeable battery. This is made possible due to the relatively low clamping voltage required to clamp the patterning device MA.

In embodiments, the number of cables and electrical equipment etc. connected to the clamp 120 may be reduced which would reduce weight and thus allow the stage to move quicker. For example, this may be in the case where the backside 127 of the patterning device MA is charged or the electrostatic layer 128 of the clamp is charged wirelessly.

Using the relatively low clamping voltage reduces or avoids the side effects of high voltage clamping mentioned above.

As a further advantage, embodiments may enable implementation to a full-field reticle or a double reticle stage.

Although a support structure MT for a patterning device MA and a patterning device MA is used to illustrate these embodiments, it will be appreciated that the electrostatic clamp 120 may be used to clamp other objects, e.g. a substrate W. Therefore, the features and advantages described are not only applicable to clamping a patterning device MA and may be for other objects as well.

More generally, a voltage supply may be configured to charge at least one of the electroadhesive layer and the object (e.g. the patterning device). The electrostatic clamp and/or the object may be respectively movable such that the electroadhesive layer is in contact with or close proximity to the object (e.g. the backside of the patterning device). The voltage supply may be configured to electrically switch on adhesion of the electroadhesive layer for clamping the object (e.g. the patterning device). The adhesion of the electroadhesive layer may be electrically switchable off for unclamping the object (e.g. connecting the backside of the patterning device to ground).

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An electrostatic clamp for clamping an object, the electrostatic clamp comprising an electroadhesive layer comprising a plurality of conductive compressible material elements coated with insulating material,
wherein the electroadhesive layer is configured to electrically change adhesion to the object for clamping and unclamping the object.

2. The electrostatic clamp according claim 1, wherein the object is a substrate or a patterning device or a mirror or a witness sample or a particle or an object of a lithographic apparatus or a semiconductor manufacturing apparatus.

3. The electrostatic clamp according to any preceding claim, wherein the elements have an average diameter in a range of 1-100nm, preferably 5-20nm.

4. The electrostatic clamp according to any preceding claim, wherein the elements comprise at least one of: fiber, foam, nanotube, carbon nanotube, nanowire, nanorod, nanoporous structure, graphene, and fullerene.

5. The electrostatic clamp according to any preceding claim, wherein the elements have a density in a range of 1-20%.

6. The electrostatic clamp according to any preceding claim, wherein the insulating material has an average thickness in a range of 0.1-50nm, preferably 1-10nm.

7. The electrostatic clamp according to any preceding claim, wherein the insualting material comprises at least one of: Al₂O₃, HfO₂, ZrO, and SiO₂.

8. The electrostatic clamp according to any preceding claim, wherein the electrostatic clamp comprises a plurality of burls and wherein the electroadhesive layer is located adjacent to the burls.

9. An assembly comprising the electrostatic clamp according to any preceding claim and a voltage supply configured to charge at least one of the electroadhesive layer and the object.

10. The assembly according to claim 9, wherein the electrostatic clamp and/or the object are respectively movable such that the electroadhesive layer is in contact with or close proximity to the object.

11. The assembly according to either of claims 9 or 10, wherein a voltage of the voltage supply is at least one of under 250V, 200V, 150V, 100V, 75V, 50V, 40V, 30V, 20V, and 10V.

12. A semiconductor manufacturing apparatus comprising the electrostatic clamp of any preceding claim

13. A lithographic apparatus arranged to project a pattern from a patterning device onto a substrate, wherein the lithographic apparatus comprises an illumination system configured to condition a radiation beam, wherein the illumination system is configured to project the radiation beam onto the patterning device, wherein the lithographic apparatus comprises the apparatus of any preceding claim and the object to be clamped comprises the patterning device or the substrate.

14. A method of operating an electrostatic clamp for clamping an object, wherein the electrostatic clamp comprises an electroadhesive layer comprising a plurality of conductive compressible material elements coated with insulating material, the method comprising:
electrically changing adhesion of the electroadhesive layer to the object for clamping the object and unclamping the object.

15. The method of claim 14, wherein the object is a substrate or a patterning device or a mirror or a witness sample or a particle or an object of a lithographic apparatus or a semiconductor manufacturing apparatus.
